# EUROPÄISCHE PATENTSCHRIFT

(11) **EP 1 515 187 B1**
(45) Veröffentlichungstag und Bekanntmachung des Hinweises auf die Patenterteilung: **28.11.2007**
(21) Anmeldenummer: 03405673.9
(22) Anmeldetag: 12.09.2003
(51) Int. Cl.: G03F 7/12, B41F 15/08

(54) **Beschichtungseinrichtung für Drucksiebe**
Coating device for printing screens
Dispositif pour le revêtement d'un écran d'impression

(43) Veröffentlichungstag der Anmeldung: 16.03.2005
(73) Patentinhaber: Grünig-Interscreen AG, 3150 Schwarzenburg (CH)
(72) Erfinder: Rohrbach, Markus, 3150 Schwarzenburg (CH)
(74) Vertreter: BOVARD AG

(56) Entgegenhaltungen:
- EP-A- 0 608 661
- EP-A- 0 730 203
- EP-A- 0 794 461
- DE-A- 4 008 712
- DE-C- 3 932 955
- US-A- 4 363 289

## Beschreibung

Die vorliegende Erfindung bezieht sich auf eine Beschichtungseinrichtung für Drucksiebe, die aus in Rahmen aufgespannten Sieben gebildet sind, umfassend einen vertikalen Ständerrahmen mit Halterungen für die Aufnahme des jeweiligen Rahmens des zu beschichtenden Drucksiebes, parallel zum Drucksieb verfahrbare Mittel, an welchen die Rakel befestigt sind, welche Rakel jeweils an das zu beschichtende Drucksieb anstellbar und von diesem abstellbar und um eine Schwenkachse, die durch die Rakelvorderkante verläuft, schwenkbar sind.

Derartige Beschichtungseinrichtungen für Drucksiebe sind bekannt. So zeigt beispielsweise die EP-A-0 608 661 eine Einrichtung zur Beschichtung von Drucksieben, welche einen Ständerrahmen aufweist, der aus zwei vertikalen Säulen, einem Sockel und die beiden Säulen verbindenden oberen Querträger zusammengesetzt ist. Das zu beschichtende Drucksieb muss zwischen die beiden vertikalen Säulen in die entsprechenden Halterungen eingesetzt werden. Jeweils an der vorderen vertikalen Säule und an der hinteren vertikalen Säule sind verfahrbare Mittel angebracht, die jeweils eine Rakel tragen. Die Vorderseite des zu beschichtenden Drucksiebes wird durch das verfahrbare Mittel mit der daran angebrachten Rakel der einen Säule beschichtet, während die Rückseite durch die verfahrbaren Mittel mit der daran angebrachten Rakel der anderen Säule beschichtet wird.

Mit dieser Einrichtung kann in problemloser Weise ein Drucksieb einseitig oder beidseitig beschichtet werden. Die Einrichtung ist aber relativ teuer, da für beide zu beschichtenden Seiten eines Drucksiebes verfahrbare Mittel mit darin gehaltener Rakel und ein entsprechender Ständer erforderlich sind. Das Einsetzen und Herausnehmen eines Drucksiebes in die bzw. aus der Einrichtung ist wegen der beiden Säulen, die durch einen oberen Querträger miteinander verbunden sind, relativ kompliziert, dies muss durch Einschieben von der Seite aus erfolgen.

Die Aufgabe der vorliegenden Erfindung besteht nun darin, eine Beschichtungseinrichtung für Drucksiebe zu schaffen, die einen einfacheren Aufbau aufweist und demzufolge kostengünstiger hergestellt werden kann, mit welcher aber die Drucksiebe einseitig sowie zweiseitig beschichtet werden können. Zudem soll das Einsetzen eines zu beschichtenden Drucksiebes in diese Einrichtung und das Herausnehmen des beschichteten Drucksiebes aus dieser Einrichtung vereinfacht werden.

Erfindungsgemäss erfolgt die Lösung dieser Aufgabe dadurch, dass der Ständerrahmen aus einem vertikal angeordneten Profil gebildet ist, entlang welcher ein verfahrbares Mittel geführt verfahrbar ist, welches eine Rakel trägt und dass an diesem vertikalen Profil die Halterungen für die Aufnahme eines Rahmens mit aufgespanntem Sieb höhenverstellbar angebracht sind, welche Halterungen mit Umstellmitteln ausgestattet sind, die so umstellbar sind, dass der Abstand der Beschichtungsebene des eingesetzten Drucksiebes vom verfahrbaren Mittel bei der Beschichtung der Vorderseite bzw. der Rückseite im wesentlichen gleich ist.

In diese Einrichtung lässt sich ein zu beschichtendes Drucksieb in einfacher Weise von vorne einsetzen und wieder entnehmen. Wenn die eine Seite dieses Drucksiebs beschichtet ist, kann es, falls erforderlich, herausgenommen, gedreht und wieder eingesetzt werden, mit der selben Beschichtungsanordnung kann dann auch die andere Seite des Drucksiebes beschichtet werden. Um dies in einfacher Weise zu ermöglichen, können die Umstellmittel an den Halterungen umgestellt werden, der Abstand der Beschichtungsebene des zu beschichtenden Drucksiebes vom verfahrbaren Mittel und der darin gehaltenen Rakel bleibt gleich. Am verfahrbaren Mittel und an der Rakel muss somit nichts verändert werden.

In vorteilhafter Weise umfassen die Halterungen jeweils einen Tragarm, der im wesentlichen symmetrisch zum vertikalen Profil angeordnet ist, an dessen Endbereichen jeweils ein Halteelement für den Rahmen angebracht ist, das jeweils aus zwei Backen gebildet ist, zwischen welche das entsprechende Rahmenteil bei eingesetztem Rahmen zu liegen kommt, wobei die Halteelemente von einer ersten Position, bei welcher die Auflagefläche der einen Backe in der Beschichtungsebene liegt, um eine Schwenkachse in eine zweite Position verschwenkbar ist, bei welcher die Auflagefläche der anderen Backe in der Beschichtungsebene liegt. Dadurch lassen sich in sehr einfacher Weise die erforderlichen Umstellungen vornehmen, wenn die Vorderseite oder die Rückseite eines Drucksiebes beschichtet werden soll.

Eine weitere vorteilhafte Ausgestaltung der Erfindung besteht darin, dass an jeder Stirnseite des Tragarms der oberen und unteren Halterung ein Schwenklager angebracht ist, in welchem die jeweilige entsprechende Schwenkachse gelagert ist, und dass die Schwenkachse die beiden jeweils stirnseitig angebrachten Halteelemente eines Tragarms miteinander verbindet. Neben dem einfachen Aufbau der Lageranordnungen lassen sich somit beide Halteelemente eines Tragarms durch eine Handhabung gemeinsam verschwenken.

In vorteilhafterweise ist die Schwenklage der Halteelemente in der ersten Position und in der zweiten Position durch Anschlagelemente festgelegt, beim Umstellen der Halteelemente wird die entsprechende Position automatisch ohne Nachstellen eingenommen.

Zur weiteren Erleichterung der Verschwenkung der Halteelemente pro Halterung ist ein Bedienerhebel angebracht, mit welchen die Halteelemente in der ersten und in der zweiten Position arretierbar sind.

Um ein einfaches Einsetzen und Herausnehmen des Drucksiebes in die bzw. aus der Beschichtungseinrichtung zu ermöglichen, ist die untere Halterung für das Drucksieb auf einer vorgegebenen Höhe am vertikalen Profil befestigbar, während die obere Halterung bezüglich der Höhe entlang des vertikalen Profils verfahrbar und in der gewünschten Höhe arretierbar ist.

In vorteilhafter Weise wirkt die obere Halterung mit einem entsprechend entlang des vertikalen Profils verfahrbaren Gegengewicht zusammen. Dadurch kann die obere Halterung in einfacher Weise verfahren und in der gewünschten Einstellung arretiert werden.

Eine weitere vorteilhafte Ausgestaltung der Erfindung besteht darin, dass das verfahrbare Mittel aus einem Wagen besteht, welcher mit einem Antrieb versehen ist, mittels welchem er entlang des vertikalen Profils verfahrbar ist, und dass die Rakel über einen Scherenantrieb am Wagen gehalten ist und mit diesem an das zu beschichtende Drucksieb anstellbar und von diesem abstellbar ist. Dadurch kann mit einem einfachen Aufbau ein optimaler Ablauf des Beschichtungsvorgangs erreicht werden.

In vorteilhafter Weise ist zwischen Rakel und Scherenantrieb ein Verschwenkmechanismus vorgesehen, bestehend aus kreisbahnförmigen Führungen, entlang welcher die Rakel über einen Antrieb verfahrbar und um deren Vorderkante verschwenkbar ist. Mit diesem einfachen Aufbau kann die Rakelwanne im an das Drucksieb angestellten Zustand gekippt und das Drucksieb beschichtet werden.

Eine Ausführungsform der Erfindung wird nachfolgend anhand der beiliegenden Zeichnung beispielhaft näher erläutert. Es zeigt
Fig. 1 eine Seitenansicht einer erfindungsgemässen Beschichtungseinrichtung für Drucksiebe;
Fig. 2 eine Ansicht von vorn auf die Beschichtungseinrichtung gemäss Fig. 1;
Fig. 3 in vereinfachter Darstellung den Wagen der Beschichtungseinrichtung mit eingesetzter Rakelwanne, wobei der Antrieb zum An- und Abstellen der Rakel an das zu beschichtende Drucksieb und zum Verschwenken ersichtlich sind;
Fig. 4 den Wagen mit der Rakeleinrichtung, aufgesetzt auf das vertikal angeordnete Profil, wobei der Antrieb zum Verfahren des Wagens ersichtlich ist;
Fig. 5 den Wagen mit eingesetzter Rakelwanne, wobei die Rakel sich im an das Drucksieb angestellten Zustand befindet;
Fig. 6 eine Schnittdarstellung durch den Tragarm einer Halterung;
Fig. 7 eine Ansicht auf den Tragarm mit den stirnseitig angebrachten Halterungen, teilweise im Schnitt dargestellt;
Fig. 8 eine Ansicht auf die Halterung, wobei sich das Halteelement in der ersten Position befindet; und
Fig. 9 eine Ansicht auf die Halterung, wobei sich das Halteelement in der zweiten Position befindet.

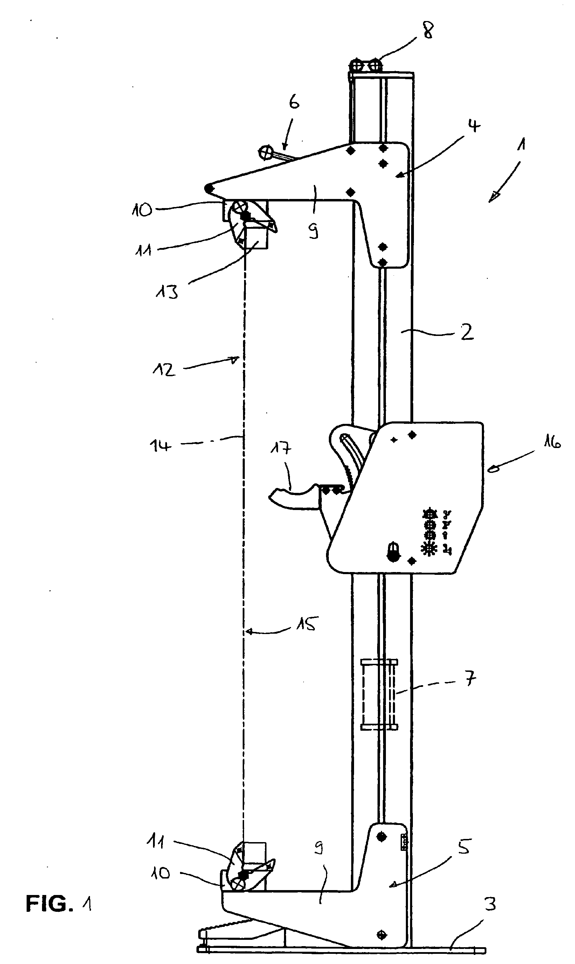

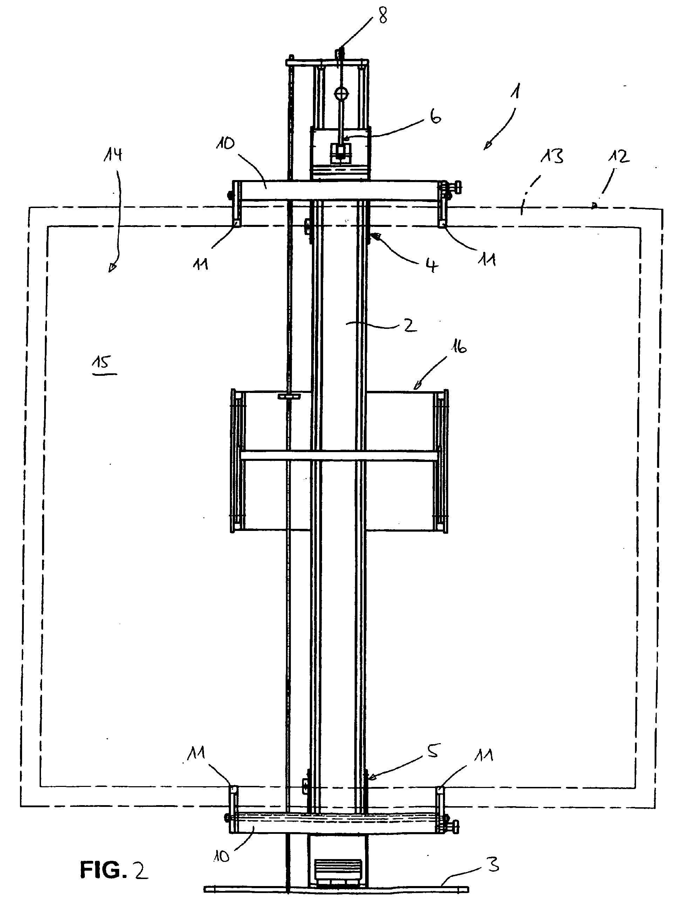

Wie aus den Fig. 1 und 2 ersichtlich ist, umfasst die Beschichtungseinrichtung 1 ein vertikal angeordnetes Profil 2. Dieses vertikale Profil 2 ist auf einer Sockelplatte 3 befestigt. Am vertikalen Profil 2 ist eine obere Halterung 4 und eine untere Halterung 5 angebracht. Die untere Halterung 5 kann in bekannter Weise auf bestimmten Höhen am vertikalen Profil 2 befestigt werden, die obere Halterung 4 ist entlang des vertikalen Profils 2 verfahrbar und kann über die Arretiereinrichtung 6 in bekannter Weise in jeder gewünschten Höhe arretiert werden. Um das Verfahren der oberen Halterung 4 für eine Bedienerperson möglichst einfach zu gestalten, wirkt dieses in bekannter Weise mit einem Gegengewicht 7 zusammen, welches im vertikalen Profil 2, das im vorliegenden Ausführungsbeispiel als Hohlprofil ausgebildet ist, angeordnet ist, wobei das Gegengewicht 7 und die obere Halterung 4 über einen Seilzug 8 miteinander verbunden sind.

Die obere Halterung 4 und die untere Halterung 5 weisen jeweils einen Ausleger 9 auf, der vom vertikalen Profil 2 absteht. Im Endbereich dieser Ausleger 9 ist jeweils ein Tragarm 10 befestigt, der quer zum vertikalen Profil 2 ausgerichtet ist und im wesentlichen symmetrisch zum vertikalen Profil 2 angeordnet ist. An den jeweiligen Endbereichen jedes Tragarms 10 ist ein Halteelement 11 angebracht, die im Detail später noch beschrieben werden.

In diese Halteelemente 11 kann ein zu beschichtendes Drucksieb 12 eingesetzt werden, das in bekannter Weise aus einem Rahmen 13 besteht, auf welchen das Sieb 14 aufgespannt ist. Durch dieses Sieb 14 wird die Beschichtungsebene 15 gebildet, in welcher der später noch beschriebene Beschichtungsvorgang ausgeführt wird.

Zum Einsetzen des Drucksiebes 12 in die Beschichtungseinrichtung 1 wird die untere Halterung 5 auf einer bestimmten Höhe am vertikalen Profil 2 befestigt. Das Drucksieb 12 wird in die Halteelemente 11 der unteren Halterung 5 eingesetzt und im wesentlichen vertikal ausgerichtet. Die obere Halterung 4 wird dann so weit nach unten verfahren, bis der obere Teil des Rahmens 13 in die Halteelemente 11 der oberen Halterung eingeführt ist. Danach wird über die Arretiereinrichtung 6 die obere Halterung 4 bezüglich des vertikalen Profils 2 verriegelt. Das Drucksieb 12 wird so in der Beschichtungseinrichtung 1 gehalten.

Entlang des vertikalen Profils 2 ist ein Wagen 16 verfahrbar, an welchen die Rakel 17 befestigt ist.

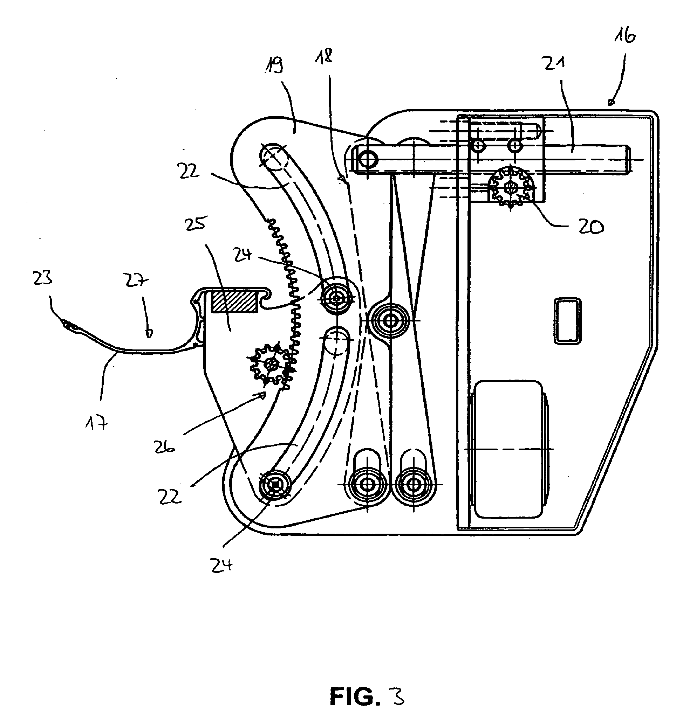

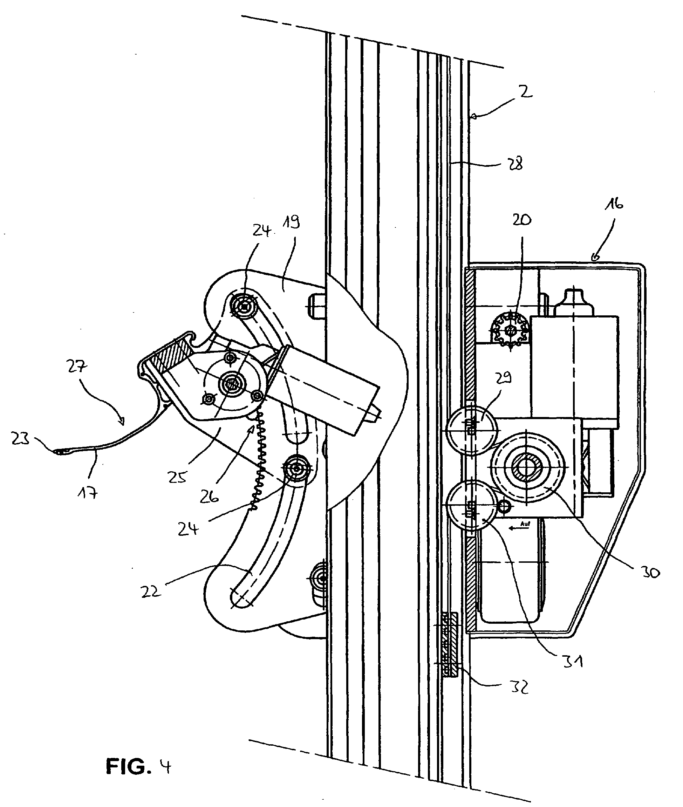

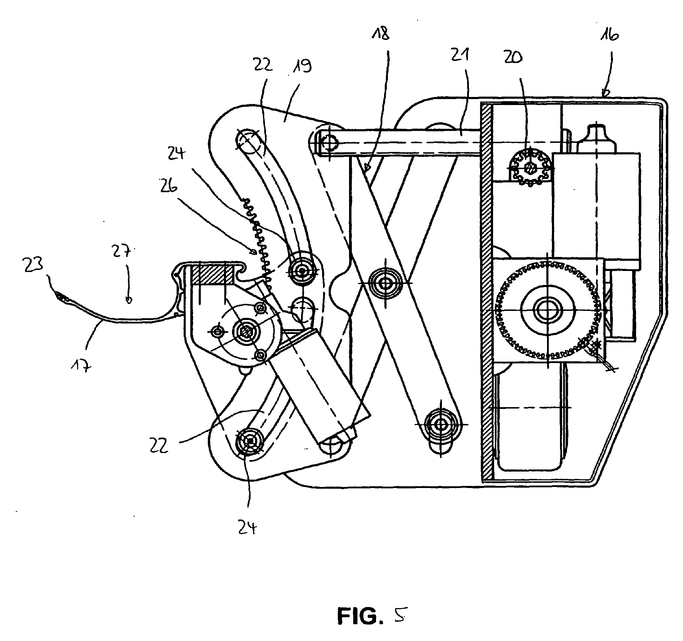

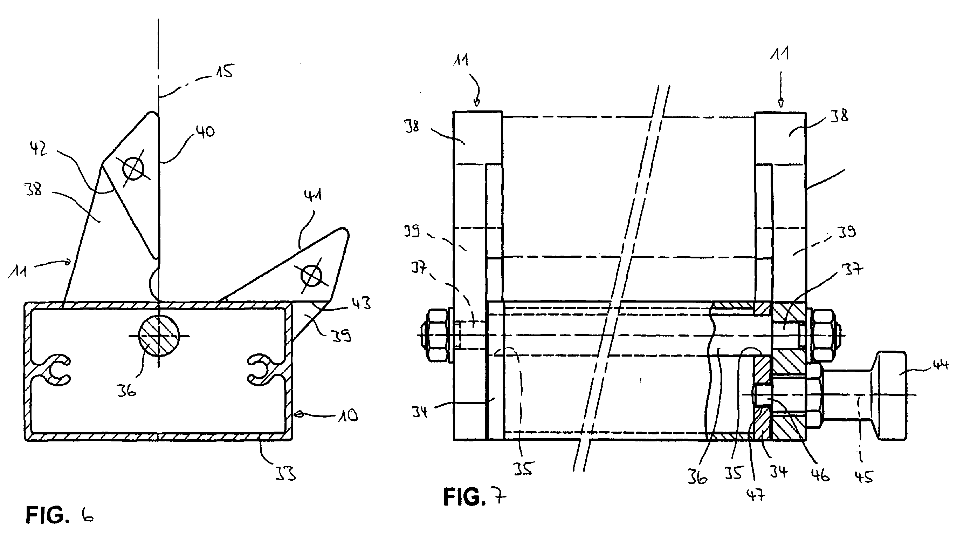

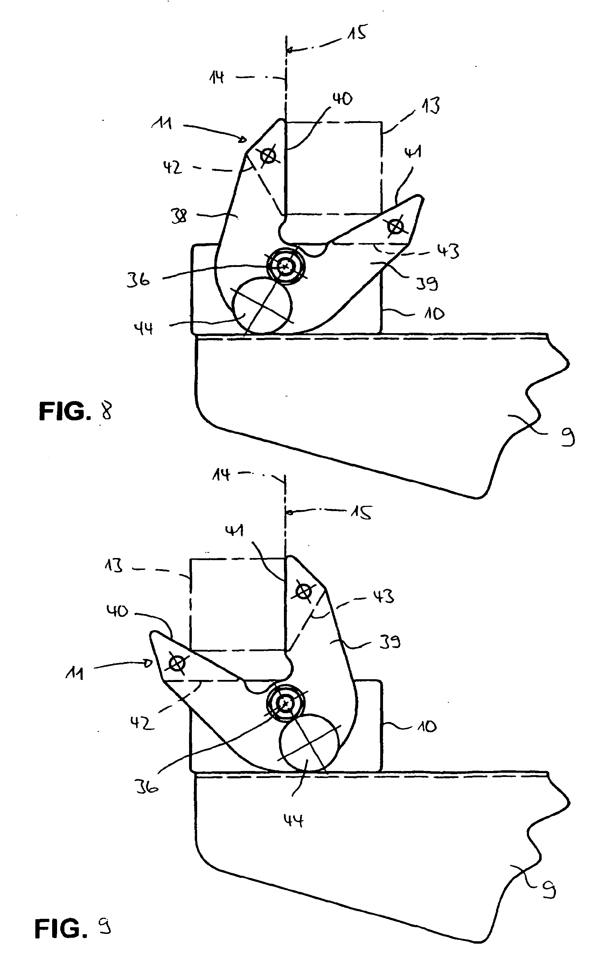

Wie aus den Fig. 3 bis 5 ersichtlich ist, ist am Wagen 16 ein Scherenantrieb 18 angebracht, dessen eines Ende am Wagen 16 befestigt ist, während das andere Ende an einem Träger 19 angelenkt ist, an welchem die Rakel 17 gehalten ist. Über den Scherenantrieb 18 lässt sich der Träger 19 mit dem daran angebrachten Rakel 17, angetrieben über das antreibbare Zahnritzel 20 und die mit diesem zusammenwirkenden Zahnstange 21, gegen das zu beschichtende Drucksieb 12 (Fig. 1) anstellen. Die vom Drucksieb abgestellte Position ist in Fig. 3 dargestellt, während die an das Drucksieb angestellte Position in Fig. 5 ersichtlich ist.

Im Träger 19 sind kreisbahnförmige Führungen 22 angebracht, deren Zentrum in der Vorderkante 23 der Rakel 17 liegt. Entlang dieser kreisbahnförmigen Führungen 22 sind Führungsbolzen 24 verfahrbar, die an der Rakelhalteeinrichtung 25 angebracht sind. Über einen Zahnstangenantrieb 26 kann die Rakelhalteeinrichtung 25 mit der darin eingesetzten Rakel 17 um die Vorderkante 23 der Rakel 17 verschwenkt werden. Hierbei ist in Fig. 3 und 5 die horizontale Lage der Rakel 17 und der durch diese gebildete Wanne 27, die stirnseitig mit Wänden abgeschlossen ist, dargestellt, während in Fig. 4 die verschwenkte Lage dargestellt ist, in welcher das in der Rakelwanne 27 sich befindende flüssige Medium in Kontakt gebracht wird mit dem zu beschichtenden Drucksieb. Das Drucksieb wird nun beschichtet, indem der Wagen 16 von unten nach oben verfährt. Im an das Drucksieb angestellten Zustand ändert sich die Lage der Vorderkante 23 der Rakel 17 bezüglich des Drucksiebs auch beim Verschwenken nicht, die Rakel 17 kann somit in der Position, wie sie in Fig. 3 dargestellt ist, an das Drucksieb angestellt werden und danach zum Beschichten verschwenkt werden.

Wie bereits erwähnt worden ist, verfährt der Wagen 16 während des Beschichtungsvorgangs von unten nach oben entlang des vertikalen Profils 2. Zum Antrieb des Wagens ist, wie aus Fig. 4 ersichtlich ist, am vertikalen Profil 2 ein Zahnriemen 28 befestigt, der um eine erste am Wagen 16 angebrachte Umlenkrolle 29 gelegt ist, danach ein antreibbares, am Wagen 16 befestigtes Antriebsrad 30 umschlingt, und um eine zweite am Wagen 16 befestigte Umlenkrolle 31 gelegt ist. Die Enden des Zahnriemens sind jeweils am vertikalen Profil 2 über Befestigungsmittel 32 befestigt. Durch Verdrehen der Antriebsrolle 30 bewegt sich der Wagen 16 in der entsprechenden Richtung entlang des vertikalen Profils 2, in bekannter Weise geführt durch entsprechende Führungen.

Sämtliche Steuerungs- und Antriebsmittel, die zum Beschichten eines Drucksiebes erforderlich sind, sind im Wagen 16 untergebracht, wodurch sich der Aufbau der Beschichtungseinrichtung 1 vereinfacht.

In den Fig. 6 bis 9 sind die Halteelemente 11 dargestellt, die jeweils am stirnseitigen Ende am jeweiligen Tragarm 10 angebracht sind. Wie aus den Fig. 6 und 7 entnehmbar ist, besteht der Tragarm 10 aus einem rechteckförmigen Hohlprofil 33, an dessen stirnseitigen Enden jeweils eine Abdeckplatte 34 angebracht ist. Diese Abdeckplatten 34 weisen eine Durchgangsbohrung 35 auf, die als Schwenklager für eine Schwenkachse 36 dienen. Diese Schwenkachse 36 erstreckt sich über die ganze Länge des jeweiligen Tragarms 10 und weist Abschnitte 37 auf, die über die Abdeckplatten 34 hinausragen und einen geringeren Durchmesser aufweisen. Auf diesen Schwenkachsenabschnitten 37 ist jeweils ein Halteelement 11 verdrehfest befestigt, die jeweils einander gegenüberliegenden Halteelemente 11 eines Tragarms können somit gemeinsam über die Schwenkachse 36 verschwenkt werden.

Jedes Halteelement 11 ist aus zwei Backen 38 und 39 gebildet. Jede der beiden Backen 38 und 39 weist jeweils eine Auflagefläche 40 bzw. 41 auf. Zusätzlich ist jede der Backen 38 und 39 mit einem Anschlagelement 42 bzw. 43 versehen.

In Fig. 8 ist die Situation dargestellt, in welcher die Halteelemente 11 des jeweiligen Tragarms 10 in eine erste Position geschwenkt sind. In dieser ersten Position ist das Sieb 14 und demzufolge die Beschichtungsebene 15 linksseitig vom Rahmen 13 angeordnet. Der Rahmen 13 und das Sieb 14 liegen somit an der Auflagefläche 40 der Backe 38 an, während sich die gegenüberliegende Kante des Rahmens 13 auf der Auflagefläche 41 der Backe 39 abstützt. In dieser ersten Position liegt das Anschlagelement 43 der Backe 39 auf dem Tragarm 10 auf.

Durch Umschwenken der Halteelemente 11 können diese aus der ersten Position gemäss Fig. 8 in eine zweite Position gebracht werden, die in Fig. 9 dargestellt ist. Diese zweite Position dient dazu, dass das Drucksieb 12 in der gewendeten Lage gehalten werden kann, wodurch die Rückseite des Drucksiebes 12 beschichtet werden kann. In dieser zweiten Position liegt der Rahmen 13 und demzufolge das Sieb 14 an der Auflagefläche 41 der Backe 39 an. Die gegenüberliegende Kante des Rahmens 13 liegt auf der Auflagefläche 40 der Backe 38 auf. In dieser zweiten Position liegt das Anschlagelement 43 auf dem Tragarm 10 auf.

Die beiden durch die Auflagefläche 40 und 41 gebildeten Ebenen jedes Halteelementes 11 schneiden sich in der Schwenkachse 36. Mit dieser Anordnung wird erreicht, dass sich das Sieb 14 und demzufolge die Beschichtungsebene 15 immer genau über dieser Schwenkachse 36 liegt, dies bedeutet, dass der Abstand der Beschichtungsebene 15 vom verfahrbaren Mittel immer gleich ist, unabhängig davon, ob die Vorderseite oder die Rückseite dieses Drucksiebes beschichtet werden soll. Dadurch können die Vorderseite und die Rückseite des Drucksiebes 12 mit der Beschichtungseinrichtung 1 beschichtet werden, ohne dass am Wagen 16 oder am Rakel 17 irgend etwas verstellt werden muss. Dies erleichtert den Beschichtungsvorgang in beträchtlicher Weise.

Zur Erleichterung der Vornahme der Umstellung der Halteelemente 11 von der ersten Position in die zweite Position ist an einem der Halteelemente 11 ein Bedienerhebel 44 angebracht. Dieser Bedienerhebel 44 umfasst in bekannter Weise in der zentralen Achse 45 einen axial verschiebbaren Stift 46, der in eine jeweils entsprechend an der Abdeckplatte 34 eingelassene Bohrung 47 hineinragt, zum Verschwenken aus dieser herausgezogen werden kann und im verschwenkten Zustand in die entsprechende weitere Bohrung wieder eindringt und somit die Halteelemente 11 in der ersten Position bzw. in der zweiten Position verriegelt.

Mit dieser einfach aufgebauten Beschichtungseinrichtung können die Vorderseite und die Rückseite eines Drucksiebes beschichtet werden, ohne dass an der Rakelhalterung oder Rakelführung irgend etwas verstellt werden muss. Lediglich die Halteelemente müssen entsprechend eingestellt werden, je nachdem, ob die Vorderseite oder die Rückseite des Drucksiebes beschichtet wird.

## Patentansprüche

1. Beschichtungseinrichtung für Drucksiebe (12), die aus in Rahmen (13) aufgespannten Sieben gebildet sind, umfassend einen vertikalen Ständerrahmen mit Halterungen (4, 5) für die Aufnahme des jeweiligen Rahmens (13) des zu beschichtenden Drucksiebes (12), parallel zum Drucksieb (12) verfahrbare Mittel (16), an welchen die Rakel (17) befestigt sind, welche Rakel (17) jeweils an das zu beschichtende Drucksieb (12) anstellbar und von diesem abstellbar und um eine Schwenkachse, die durch die Rakelvorderkante (23) verläuft, schwenkbar sind, **dadurch gekennzeichnet, dass** der Ständerrahmen aus einem einzelnen vertikal angeordneten Profil (2) gebildet ist, entlang welchem ein verfahrbares Mittel (16) geführt verfahrbar ist, welches eine Rakel (17) trägt, und dass an diesem vertikalen Profil (2) die Halterungen (4, 5) für die Aufnahme des Rahmens (13) mit aufgespanntem Sieb (14) höhenverstellbar angebracht sind, welche Halterungen (4, 5) mit Umstellmitteln (11) ausgestattet sind, die so umstellbar sind, dass der Abstand der Beschichtungsebene (15) des eingesetzten Drucksiebes (12) vom verfahrbaren Mittel (16) bei der Beschichtung der Vorderseite bzw. der Rückseite im wesentlichen gleich ist.

2. Beschichtungseinrichtung für Drucksiebe nach Anspruch 1, **dadurch gekennzeichnet, dass** die Halterungen (4, 5) jeweils einen Tragarm (10) umfassen, der im wesentlichen symmetrisch zum vertikalen Profil (2) angeordnet ist, an dessen Endbereichen jeweils ein Halteelement (11) für den Rahmen (13) angebracht ist, das jeweils aus zwei Backen (38, 39) gebildet ist, zwischen welche das entsprechende Rahmenteil bei eingesetztem Rahmen (13) zu liegen kommt, und dass die Haltelemente (11) von einer ersten Position, bei welcher die Auflagefläche (40) der einen Backe (38) in der Beschichtungsebene (15) liegt, um eine Schwenkachse (36) in eine zweite Position verschwenkbar ist, bei welcher die Auflagefläche (41) der anderen Backe (39) in der Beschichtungsebene (15) liegt.

3. Beschichtungseinrichtung für Drucksiebe nach Anspruch 2, **dadurch gekennzeichnet, dass** an jeder Stirnseite des Tragarms (10) der oberen und unteren Halterung (4, 5) ein Schwenklager (35) angebracht ist, in welchem die jeweilige entsprechende Schwenkachse (36) gelagert ist, und dass die Schwenkachse (36) die beiden jeweils stirnseitig angebrachten Haltelemente (11) eines Tragarms (10) miteinander verbindet.

4. Beschichtungseinrichtung für Drucksiebe nach Anspruch 2 oder 3, **dadurch gekennzeichnet, dass** die Schwenklage der Halteelemente (11) in der ersten Position und in der zweiten Position durch Anschlagelemente (42, 43) festgelegt ist.

5. Beschichtungseinrichtung für Drucksiebe nach einem der Ansprüche 2 bis 4, **dadurch gekennzeichnet, dass** zur Verschwenkung der Halteelemente (11) pro Halterung (4, 5) ein Bedienerhebel (44) angebracht ist, mit welchen die Halteelemente (11) in der ersten Position und in der zweiten Position arretierbar sind.

6. Beschichtungseinrichtung für Drucksiebe nach einem der Ansprüche 1 bis 5, **dadurch gekennzeichnet, dass** die untere Halterung (5) für das Drucksieb (12) auf einer vorgegebenen Höhe am vertikalen Profil (2) befestigbar ist, und dass die obere Halterung (4) bezüglich der Höhe entlang des vertikalen Profils (2) verfahrbar und in der gewünschten Höhe arretierbar ist.

7. Beschichtungseinrichtung für Drucksiebe nach Anspruch 6, **dadurch gekennzeichnet, dass** die obere Halterung (4) mit einem entsprechend entlang des vertikalen Profils (2) verfahrbaren Gegengewicht (7) zusammenwirkt.

8. Beschichtungseinrichtung für Drucksiebe nach einem der Ansprüche 1 bis 7, **dadurch gekennzeichnet, dass** das verfahrbare Mittel aus einem Wagen (16) besteht, welcher mit einem Antrieb versehen ist, mittels welchem er entlang des vertikalen Profils (2) verfahrbar ist, und dass die Rakel (17) über einen Scherenantrieb (18) am Wagen (16) gehalten ist und mit diesem an das zu beschichtende Drucksieb (12) anstellbar und von diesem abstellbar ist.

9. Beschichtungseinrichtung für Drucksiebe nach Anspruch 8, **dadurch gekennzeichnet, dass** zwischen Rakel (17) und Scherenantrieb (18) ein Verschwenkmechanismus vorgesehen ist, bestehend aus kreisbahnförmigen Führungen (22), entlang welcher die Rakel (17) über einen Antrieb (26) verfahrbar und um deren Vorderkante (23) verschwenkbar ist.

## Claims

1. Coating device for printing screens (12), which are made up of screens mounted in frames (13), comprising an upright frame with holders (4, 5) for receiving the respective frame (13) of the printing screen (12) to be coated, parallel to the printing screen (12) drivable means (16), to which the doctor blades (17) are attached, which doctor blades (17) are each able to be put on the printing screen (12) to be coated and able to be taken off the same, and are pivotable about a pivot axis running through the doctor blade leading edge (23), **characterised in that** the upright frame is formed by a single, vertically disposed section (2), along which a drivable means (16) is drivable in a guided way, which means bears a doctor blade (17), and **in that** installed in a height-adjustable way on this vertical section (2) are the holders (4, 5) for receiving the frame (13) with mounted screen (14), which holders (4, 5) are provided with repositioning means (11), which are repositionable such that the spacing of the coating plane (15) of the inserted printing screen (12) from the drivable means (16) is substantially the same during the coating of the front side or respectively of the rear side.

2. Coating device for printing screens according to claim 1, **characterised in that** the holders (4, 5) each comprise a support arm (10), which is disposed substantially symmetrically to the vertical section (2), on each of whose end regions a holding element (11) is placed for the frame (13), which element is formed in each case by two jaws (38, 39), between which the respective frame portion comes to be situated with inserted frame (13), and **in that** the holding elements (11) is <sic. are> pivotable from a first position, in which the contact surface (40) of the one jaw (38) is situated in the coating plane (15), about a pivot shaft (36) into a second position, in which the contact surface (41) of the other jaw (39) is situated in the coating plane (15).

3. Coating device for printing screens according to claim 2, **characterised in that** fixed to each front side of the support arm (10) of the upper and lower holder (4, 5) is a pivot bearing (35) in which the respective corresponding pivot shaft (36) is borne, and **in that** the pivot shaft (36) connects together the two holding elements (11) each fixed on the front side of a support arm (10).

4. Coating device for printing screens according to claim 2 or 3, **characterised in that** the pivot position of the holding elements (11) in the first position and in the second position is fixed by stop elements (42, 43).

5. Coating device for printing screens according to one of the claims 2 to 4, **characterised in that** provided per holder (4, 5) for pivoting of the holding elements (11) is an operating handle (44) with which the holding elements (11) are able to be stopped in the first position and in the second position.

6. Coating device for printing screens according to one of the claims 1 to 5, **characterised in that** the lower holder (5) for the printing screen (12) is able to be fixed at a predetermined height on the vertical section (2), and **in that** the upper holder (4) is drivable in relation to the height along the vertical section (2) and is able to be stopped at the desired height.

7. Coating device for printing screens according to claim 6, **characterised in that** the upper holder (4) co-operates with a counterweight (7) correspondingly drivable along the vertical section (2).

8. Coating device for printing screens according to one of the claims 1 to 7, **characterised in that** the drivable means consist of a carriage (16), which is provided with a drive by means of which it is drivable along the vertical section (2), and **in that** the doctor blade (17) is held on the carriage (16) via a scissors-like drive (18) and with this drive can be put on and taken off of the printing screen (12) to be coated.

9. Coating device for printing screens according to claim 8, **characterised in that** provided between doctor blade (17) and scissors-like drive (18) is a pivot mechanism, consisting of circular-path-shaped guides (22), along which the doctor blade (17) is drivable via a drive (26) and is pivotable about its leading edge (23).

## Revendications

1. Dispositif de revêtement pour des écrans d'impression (12) qui sont formés d'écrans tendus dans des cadre (13), comprenant un cadre support vertical avec des fixations (4, 5) pour le logement du cadre respectif (13) de l'écran d'impression à revêtir (12), des moyens (16) mobiles parallèlement à l'écran d'impression (12) sur lesquels sont fixées les racles (17), racles (17) qui sont pivotantes autour d'un axe de pivotement s'étendant à travers le bord avant de racle (23) respectivement et qui peuvent être placées contre ou être éloignées de l'écran d'impression à revêtir (12), **caractérisé en ce que** le cadre support se compose d'un profil unique 82) disposé verticalement le long duquel est guidé mobile un moyen mobile (16) qui porte une racle et **en ce que** sur ce profilé vertical (2) sont ménagées les fixations (4, 5) pour le logement du cadre (13) avec l'écran tendu (14), et, ce de manière réglable en hauteur, fixations (4, 5) qui sont munies de moyens de transposition (11) qui son transposables de sorte que la distance du plan de revêtement (15) de l'écran d'impression inséré (12) par rapport au moyen mobile (16) est sensiblement identique lors du revêtement de la face avant respectivement arrière.

2. Dispositif de revêtement pour écrans d'impression selon la revendication 1, **caractérisé en ce que** les fixations (4, 5) comprennent respectivement un bras support (10) qui est disposé sensiblement symétrique par rapport au profilé vertical (2) aux zones d'extrémités duquel est placé respectivement un élément de retenue (11) pour le cadre (13) élément qui se compose de deux mâchoires (38, 39) entre lesquelles vient s'appliquer la partie de cadre correspondante quand le cadre (13) est inséré et **en ce que** les éléments de retenue (11) sont pivotants d'une première position dans laquelle se trouve la surface d'application(40) d'une mâchoire (38) dans le plan de revêtement (15) autour d'un axe de pivotement (36) dans une seconde position où la surface d'application (41) de l'autre mâchoire (39) se trouve dans le plan de revêtement (15).

3. Dispositif de revêtement pour écrans d'impression selon la revendication 2, **caractérisé en ce que** sur chaque face frontale du bras support (10) de la fixation supérieure et inférieure (4, 5), est placé un palier pivotant (35) dans lequel l'axe pivotant respectif correspondant (36) et **en ce que** l'axe de pivotement (36) relie entre eux les deux éléments de retenue (11) d'un bras support (10) placés respectivement sur la face avant.

4. Dispositif de revêtement pour écrans d'impression selon la revendication 2 ou 3, **caractérisé en ce que** la position pivotée des éléments de retenue (11) est fixée dans la première position et dans la seconde position par des éléments de butée (42, 43).

5. Dispositif de revêtement pour écrans d'impression selon l'une des revendications 2 à 4, **caractérisé en ce que** pour le basculement de l'élément de retenue (11), il est aménagé par fixation (4 ,5) un levier de commande (44) avec lequel peuvent être bloqués les éléments de retenue (11) dans la première position ou dans la seconde position.

6. Dispositif de revêtement pour écrans d'impression selon l'une des revendications 1 à 5, **caractérisé en ce que** la fixation inférieure (5) pour l'écran d'impression (12) peut être fixée à une hauteur prédéterminée sur le profilé vertical (2) et **en ce que** la fixation supérieure (4) est mobile par rapport à la hauteur le long du profilé vertical (2) et peut être bloquée à la hauteur souhaitée.

7. Dispositif de revêtement pour écrans d'impression selon la revendication 6, **caractérisé en ce que** la fixation supérieure (4) coopère avec un contrepoids (7) mobile en conséquence le long du profilé vertical(2).

8. Dispositif de revêtement pour écrans d'impression selon l'une des revendications 1 à 7, **caractérisé en ce que** le moyen mobile se compose d'un chariot (16) qui est muni d'un entraînement au moyen duquel il est mobile le long du profilé vertical (2) et **en ce que** la racle (17) est maintenue par une commande par parallélogramme (18) sur le chariot (16) et peut être appliquée contre l'écran d'impression à revêtir (12) ou en être éloignée.

9. Dispositif de revêtement pour écrans d'impression selon la revendication 8, **caractérisé en ce qu'**entre la racle (17) et la commande par parallélogramme (18), il est prévu un mécanisme de pivotement se composant de guides (22) en forme d'orbite le long desquels la racle (17) est mobile par un entraînement (26) et pivotante autour de leur bord avant (23).
